**Europäisches Patentamt**

**European Patent Office**

**Office européen des brevets**

(11) Veröffentlichungsnummer: **0 457 071 A2**

# (12) EUROPÄISCHE PATENTANMELDUNG

(21) Anmeldenummer: **91106650.4**

(22) Anmeldetag: **25.04.91**

(51) Int. Cl.⁵: **H05K 3/10, H05K 3/20**

(30) Priorität: **12.05.90 DE 4015325**

(43) Veröffentlichungstag der Anmeldung:
**21.11.91 Patentblatt 91/47**

(84) Benannte Vertragsstaaten:
**BE DE FR GB IT LU NL SE**

(71) Anmelder: **DU PONT DE NEMOURS (DEUTSCHLAND) GMBH**
**Du Pont Strasse 1**
**W-6380 Bad Homburg(DE)**

(72) Erfinder: **Dudek, Dietmar, Dr.**
**Uhlandstrasse 11**
**W-6070 Langen(DE)**
Erfinder: **Pfeiffer, Thomas, Dr.**
**25 Glenbarry Drive**
**Wilmington, Delaware 19808(US)**
Erfinder: **Häfner, Carola**
**Lilienstrasse 1**
**W-6072 Dreieich 2(DE)**
Erfinder: **Jensen, Richard H.**
**5406 Crestline Road**
**Wilmington, Delaware 19808(US)**

(54) **Verfahren zur Erzeugung feiner Leiterbahnen.**

(57)
2.1 Es besteht Bedarf an einem Verfahren zur Erzeugung von Leiterbahnen für elektrische Schaltkreise, welches eine hohe Packungsdichte der Leiterbahnen ermöglicht und sich flexibel an eine große Zahl verschiedener Leiter- und Trägermaterialien anpassen läßt.

2.2 Man erzeugt zunächst ein Pulverbild des Leiterbahnmusters mittels eines vorzugsweise photographisch hergestellten positiven klebrigen Musters auf einem Zwischenträger. Das klebrige Muster wird entfernt und das Pulverbild auf einen endgültigen Träger übertragen, wobei es entweder vor oder nach dem Übertragen durch Sintern zu einem Leiterbahnmuster verdichtet wird.

2.3 Herstellung von Schaltkreisen, insbesondere für die Hybridtechnik.

EP 0 457 071 A2

Die Erfindung betrifft ein Verfahren zur Erzeugung feiner Leiterbahnen aus metallischen Leitwerkstoffen, beispielsweise für gedrückte Schaltungen und Mehrschicht-Schaltungen auf starren und flexiblen Trägern mit ebenen oder gekrümmten Oberflächen.

Mit der fortschreitenden Miniaturisierung der integrierten Schaltkreise wächst auch die Dichte der Verbindungen zwischen Schaltkreisen und Substrat. Die bekannten technischen Möglichkeiten erlauben es nur bis zu einer bestimmten Grenze, diesem Umstand durch schmalere, dichter gepackte Leiterbahnen zu entsprechen. Man kann auch nicht beliebig viele Schaltungsebenen in einer Mehrschicht-Schaltung vorsehen, um die Packungsdichte zu erhöhen, weil dabei die durch die Miniaturisierung gewonnene Geschwindigkeit der Signalverarbeitung wieder verlorengeht.

Die veröffentlichte Patentanmeldung WO 86 03 930-A1 lehrt die Herstellung von feinen Leiterbahnen für elektrische Schaltkreise auf einem Träger unter Benutzung eines Zwischenträgers mit einer Hilfsoberfläche, enthaltend die Schritte
- Auswahl des Trägers und des Zwischenträgers dergestalt, daß deren Beschaffenheit es gestattet, beide nach einem Inkontaktbringen wieder voneinander zu trennen,
- Ausbildung eines Musters, welches die Form der Leiterbahnen festlegt, auf der Hilfsoberfläche,
- Auftragen eines elektrisch leitfähigen Materials auf der Hilfsoberfläche in der durch das Muster definierten Form,
- Entfernung des Musters von der Hilfsoberfläche, wobei nur das leitfähige Material zurückbleibt,
- Anheften des leitfähigen Materials an den Träger mit einer Haftkraft, die größer als die Haftkraft des leitfähigen Materials an der Hilfsoberfläche ist, durch Inkontaktbringen von Träger und Hilfsoberfläche,
- Trennen von Träger und Hilfsoberfläche, wobei das elektrisch leitfähige Material in der vom Muster bestimmten Form am Träger haften bleibt.

Die in der genannten Veröffentlichung beschriebene Ausführungsform zu dieser allgemein gehaltenen Lehre verwendet als Muster ein Negativmuster, welches aus einem flüssigen oder Trockenfilm-Photoresist gebildet wird. "Negativ" bedeutet hier, daß das musterbildende Material an den Stellen, die dem zu bildenden Leiterbahnmuster entsprechen, nicht vorhanden ist. In den offenen Bereichen dieses Negativs wird als elektrisch leitfähiges Material kompaktes Metall galvanisch abgeschieden. Diese Ausführungsform ist jedoch mit einer Reihe von Einschränkungen behaftet.

Zunächst hängt die erreichbare Leiterbahnfeinheit vom Auflösungsvermögen des Photoresists ab. Dieses liegt bei Trockenfilmresists um 40 μm. Das Verfahren ist also für Leiterbahnen, deren Breite unter 40 μm liegen soll, nicht anwendbar.

Weiterhin können das Material des Trägers und das leitfähige Material nicht beliebig gewählt werden. Werden z.B. Leiterbahnen aus kompaktem Metall auf grüne Keramikfolien übertragen, dann werden sie infolge der Schrumpfung beim nachfolgenden Sintern abgelöst und zerstört. Das wird beispielsweise durch die US 47 53 694 belegt, welche einen von der vorliegenden Erfindung verschiedenen Vorschlag zur Lösung dieses speziellen Problems macht.

Schließlich ist es bei dem bekannten Verfahren notwendig, die Hilfsoberfläche mit einem leitfähigen Überzug zu versehen, wenn der Zwischenträger nicht leitfähig ist. Wird dieser Überzug beim Trennen mit übertragen, dann muß er in einem zusätzlichen Ätzprozeß entfernt werden.

Die Erfindung stellt sich daher die Aufgabe, das bekannte Verfahren derart fortzubilden, daß die genannten Einschränkungen überwunden werden.

Diese Aufgabe wird durch ein Verfahren nach dem Anspruch 1 gelöst.

Es wurde nämlich überraschenderweise gefunden, daß sich nicht nur fertige Leiterbahnmuster aus kompaktem Metall, sondern auch Pulverbilder nach dem Entfernen des klebrigen Musters von einer Hilfsoberfläche auf einen Träger übertragen lassen, ohne daß sie beschädigt oder zerstört werden.

Die Ausführbarkeit des erfindungsgemäßen Verfahrens, insbesondere das Trennen, wird erleichtert, wenn wenigstens der Träger oder der Zwischenträger eine gewisse Flexibilität besitzen sodaß einer vom anderen abgezogen werden kann. Dies ist in der Praxis meist gegeben, wenn es sich um blattförmige Körper handelt. Man kann jedoch auch mit weitgehend starren Körpern arbeiten, wenn man beispielsweise einen auf dem anderen abrollt oder dafür sorgt, daß die Haftkraft und die Berührungsfläche zwischen dem Träger und der Hilfsoberfläche gering sind.

Als Zwischenträger geeignet sind beispielsweise Folien aus Kunststoffen wie Polyethylenterephthalat und Polyimid, Glasplatten, Bleche, vorzugsweise aus nichtrostendem Stahl, gesinterte Keramikkörper, glasierte Körper. Bei der Auswahl dieses Materials ist selbstverständlich darauf zu achten, daß es der Behandlung zur Entfernung des klebrigen Musters, beispielsweise durch Erhitzen oder Lösungsmittel, ohne Formveränderung zu widerstehen vermag.

Alle für die Herstellung von gedruckten und Hybrid-Schaltkreisen bekannten, sowohl formstabilen als auch flexiblen Trägermaterialien lassen sich verwenden, beispielsweise grüne Keramikfolien, gesinterte

2

EP 0 457 071 A2

Keramikkörper, gegebenenfalls versehen mit aufgedruckten Dielektrikumspasten oder mit auflaminierten dielektrischen Filmen, wobei diese Pasten und Filme auch lichtempfindlich sein können, Glasplatten, emaillierte Bleche, Platten und Folien aus ggf. faserverstärkten Kunststoffen wie Polyimid, Epoxyharz, Polyethylenterephthalat.

Unter einer grünen Keramikfolie wird hier ein folienartiger flexibler Körper verstanden, der ein sinterfähiges keramisches Pulver und ein organisches Bindemittel enthält. Beim Brennen der Folie verflüchtigt sich dieses Bindemittel durch Verdampfen oder Verbrennen und aus dem keramischen Anteil entsteht durch Sintern ein formbeständiger Keramikkörper, wobei eine gewisse Schrumpfung beobachtet wird. Das keramische Pulver kann beispielsweise aus Aluminiumoxid und geringen Mengen Glasfritte bestehen. Die Dicke grüner Keramikfolien liegt üblicherweise zwischen 100 und 400 μm.

Während für die Ausführung des erfindungsgemäßen Verfahrens eine möglichst glatte Hilfsoberfläche auf dem Zwischenträger vorteilhaft ist, können auch solche Träger verwendet werden, deren Oberfläche eine gewisse Rauhigkeit aufweist, solange diese geringer als die Dicke der zu erzeugenden Leiterbahnen ist. Dadurch werden Ausgleichsschichten, beispielsweise auf rauher gebrannter Keramik, überflüssig.

Als Träger kommen nicht nur Formkörper mit ebenen, sondern auch solche mit einfach gekrümmten Oberflächen, beispielsweise Zylinderflächen, in Frage.

Die Bezeichung positives klebriges Muster ist so zu verstehen, daß die Hilfsoberfläche entweder eine Beschichtung trägt, die nur an den Stellen, die dem zu bildenden Leiterbahnmuster entsprechen, klebrig ist oder die klebrig und nur an den genannten Stellen vorhanden ist. Bevorzugt wird das klebrige Muster mittels einer strahlungsempfindlichen Beschichtung gebildet, welche durch Bestrahlung ihre Klebrigkeit ändert. Dies sind sowohl Beschichtungen, die durch Bestrahlung klebrig werden (negativ arbeitende) als auch solche, die ihre ursprünglich vorhandene Klebrigkeit durch Bestrahlung verlieren (positiv arbeitende). Ein Beispiel für eine positiv arbeitende Beschichtung gibt die Patentschrift DE 12 10 321 an. Besonders geeignet sind negativ arbeitende Beschichtungen mit Dihydropyridinverbindungen nach der Patentschrift DE 27 58 209-C3 und solche mit Abkömmlingen des Nitrophenyldihydropyridins nach der Patentschrift DE 34 29 615-C1. Man kann das klebrige Muster auch durch musterartiges Auftragen eines Klebstoffes, z.B. mittels eines Druckverfahrens, erzeugen. Eine weitere Möglichkeit besteht darin, ein durch bildmäßiges Belichten und Auswaschen gebildetes Muster aus einem polymerhaltigen Gemisch durch Behandlung mit einem Weichmacher oder durch Erwärmen klebrig zu machen.

Da das Pulverbild sich hinsichtlich sowohl seiner Festigkeit als auch seiner Leitfähigkeit nicht ohne weiteres als Leiterbahnmuster eignet, ist ein Arbeitsschritt zur Verdichtung des Pulverbildes vorgesehen. Dies geschieht bevorzugt durch einen thermischen Sinterprozeß, der vorzugsweise durchgeführt wird, nachdem Träger und Hilfsoberfläche voneinander getrennt wurden.

In einer anderen bevorzugten Ausgestaltung des erfindungsgemäßen Verfahrens wird das Pulverbild nach dem Entfernen des klebrigen Musters und vor dem Anheften an den Träger, d.h. während es sich noch auf der Hilfsoberfläche befindet, einem Sinterprozeß unterworfen. Dies ermöglicht die Verwendung von Trägern, die ihrerseits nicht hinreichend

können. Dadurch wird das Verfahren für die Herstellung von Leiterbahnmustern auf Trägern aus flexiblen Kunststoffolien anwendbar. Dieser Arbeitsschritt läßt sich in besonders einfacher Weise mit dem Entfernen des Musters durch Wärmebehandlung zusammenfassen. Selbstverständlich muß in diesem Fall der Zwischenträger wärmebeständig sein und das Pulver darf keine Zusätze enthalten, welche eine hohe Haftung des gesinterten Pulvers an der Hilfsoberfläche bewirken würden. Für diese Ausführungsform sind Glasplatten oder polierte Dünnfilmkeramiken wegen ihrer besonders glatten Oberfläche als Zwischenträger gut geeignet.

Als metallhaltige Pulver können zunächst Pulver reiner Metalle oder Legierungen verwendet werden, die in ihrer chemischen Zusammensetzung dem gewünschten Leiterbahnmaterial entsprechen, z.B. Pulver aus Gold, Silber, Kupfer, Palladium, Platin, Molybdän und/oder Wolfram. Die Pulver können aber auch neben den Metallen noch Zusätze enthalten, die den Sintervorgang oder die Haftung der Leiterbahnen am Träger beeinflussen und beispielsweise nach dem Verfahren der Patentschrift DE 38 06 515-C1 inkorporiert wurden. Es ist auch möglich, zunächst ein reines Metall aufzutragen und die Zusätze in einem zweiten Auftragungsschritt hinzuzufügen, wie in der DE 39 13 115-C1 beschrieben.

Das Pulver kann beispielsweise mit einem Pinsel oder einem Wattebausch oder nach einem anderen bekannten Verfahren auf das klebrige Muster aufgetragen werden. Besonders vorteilhaft arbeitet man mit einem durch Vibration verdichteten Pulverbett nach der Patentschrift DE 37 36 391-C1.

Nach dem Auftragen des Pulvers wird das klebrige Muster entfernt. Hierfür stehen verschiedene Verfahren zur Verfügung, aus denen je nach der stofflichen Eigenart des Musters geeignete ausgewählt werden können. Beispielsweise kann ein geeignetes Lösungsmittel auf der Hilfsoberfläche kondensiert werden, dessen ablaufender Film das Mustermaterial gelöst mitführt, wie dies in der EP 01 92 301-A2

3

beschrieben ist. Wenn das klebrige Muster nur aus niedermolekularen flüchtigen Verbindungen, beispielsweise Nitrophenyldihydropyridinderivaten, besteht, kann es durch einfaches Ausheizen thermisch verflüchtigt werden. Eine weitere Möglichkeit ist das Erhitzen in Gegenwart von Sauerstoff, wodurch das Material des klebrigen Musters verbrannt wird.

Das Pulverbild besitzt nach dem Entfernen des klebrigen Musters eine gewisse Stabilität, wodurch die fehlerfreie Übertragung auf die Trägeroberfläche möglich wird. Dies ist überraschend, da für die Erzeugung des Bildes ein möglichst frei fließendes Pulver, d.h. mit möglichst geringer Formstabilität seines Schüttkörpers, verwendet wird. Die Ursache dafür ist unbekannt, es erscheint aber möglich, daß infolge der begrenzten Zeitdauer bei der Durchführung dieses Verfahrensschrittes Spuren der Substanz des klebrigen Musters oder von deren Reaktionsprodukten in den engen Spalten zwischen den sich berührenden Pulverteilchen zurückbleiben und eine gewisse Kohäsion des Pulverbildes hervorrufen.

Es ist vorteilhaft, wenn der Träger in seiner Oberflächenschicht Stoffe enthält, die bei Temperaturen zwischen 0 und 200 °C gegenüber dem auf der Hilfsoberfläche angeordneten leitfähigen Material als Klebstoff wirken. Dadurch wird der Vorgang des Anheftens gefördert. Dies kann beispielsweise eine dünne Schicht aus einem Kleber oder einem Schmelzkleber sein. Wenn der Träger aus einer grünen Keramikfolie besteht, dann kann das als Bindemittel in der Folie vorhandene organische Polymere diese Schmelzklebereigenschaft haben, sodaß das Verfahren wesentlich vereinfacht wird. Für das Anheften genügt dann, wenn Hilfsoberfläche und Träger bei einer geeigneten Temperatur zusammengepreßt werden. Es ist selbstverständlich auch möglich, das leitfähige Material durch hinreichenden Druck an eine rauhe Trägeroberfläche anzuheften, wenn die Hilfsoberfläche so glatt ist, daß die Haftkraft an ihr nach dem Andrücken geringer als am Träger ist. Eine geeignete Klebschicht auf der Trägeroberfläche läßt sich auch durch Beschichten mit einem Material, welches bei Belichtung klebrig wird und diffuse Belichtung dieser Schicht erzeugen.

In besonders einfacher Weise lassen sich Leiterbahnmuster auf keramischem Substrat herstellen, indem man das erfindungsgemäße Verfahren mit einem Träger aus einer grünen Keramikfolie durchführt. Das Metall im Pulver und das Keramikmaterial werden dazu vorteilhaft so ausgewählt, daß der Schmelzpunkt des Metalls höher als die Sintertemperatur der Keramik liegt. Eine geeignete Kombination ist beispielsweise Gold mit Du Pont Green Tape®. Bei dieser Ausführungsform erhält man überraschenderweise unabhängig vom Schrumpfungsgrad der Keramik beim Sintern ununterbrochene und gut haftende Leiterbahnen. Dies gilt insbesondere auch dann, wenn mehrere grüne Keramikfolien vor dem Sintern zwecks Erzeugung einer Mehrschichtschaltung übereinandergelegt werden.

Bei einer weiteren bevorzugten Ausführungsform des erfindungsgemäßen Verfahrens werden die Verfahrensschritte
- Erzeugung eines Pulverbildes auf dem Zwischenträger,
- Entfernung des klebrigen Musters,
- Übertragung des Pulverbildes auf die Oberfläche des Trägers einmal oder mehrmals vor dem Sintern mit dem gleichen Träger wiederholt. Wenn dabei das gleiche Muster und das gleiche leitfähige Material angewendet werden, erzielt man dickere Pulverschichten auf dem Träger. Die durch das Sintern aus dem Pulver gebildeten Leiterbahnen sind dann dicker und haben einen geringeren elektrischen Widerstand.

Diese Verstärkung des Leiterbahnmusters kann selbstverständlich auch auf einzelne Bereiche beschränkt werden, indem man das klebrige Muster entsprechend ausbildet. Auf diese Weise lassen sich auch Fehler im übertragenen Pulverbild reparieren.

Verwendet man bei der Wiederholung ein Muster, welches sich mit dem ersten Muster nur teilweise überdeckt, dann haften nach dem Sintern die Leiterbahnen des zweiten Musters überraschenderweise auch an den Überlappungsstellen einwandfrei am Träger und es tritt kein Abreißen der obenliegenden Leiterbahnen auf.

Schließlich kann man auch bei der Wiederholung ein anderes elektrisch leitendes Material verwenden. Dadurch lassen sich beispielsweise Leiterbahnen aus Legierungen aufbauen oder auch Leiterbahnen aus verschiedenen Metallen miteinander verbinden. Dabei sind nötigenfalls die Erfahrungen aus der Dickschichttechnik hinsichtlich der gegenseitigen Beeinflussung der Komponenten beim Sintern bei der Auslegung der Muster anzuwenden.

Bei Verwendung eines positiv arbeitenden lichtempfindlichen Materials kann man in bekannter Weise auf dem Zwischenträger Pulverbilder erzeugen, die in unterschiedlichen Bereichen aus verschiedenen Pulvern bestehen. Hierzu werden die Arbeitsschritte des Belichtens und Pulverauftragens mit dem gleichen Zwischenträger, jedoch verschiedenen Masken und Pulvern wiederholt. Dabei können neben den zur Erzeugung der Leiterbahnen dienenden Metallpulvern auch Pulver dielektrischer Materialien verwendet werden.

Solche kombinierten Pulverbilder lassen sich im erfindungsgemäßen Verfahren vorteilhaft einsetzen. Beispielsweise kann man ein erstes Pulverbild aus Leitmetall auf einem ersten Zwischenträger bilden und auf eine grüne Keramikfolie übertragen. Ein zweites Pulverbild enthält dann Metallpulver nur dort, wo eine Verstärkung der fertigen Leiterbahnen, etwa zur Kontaktierung, erwünscht ist, und besteht auf der ganzen übrigen Fläche aus einem dielektrischen Pulver. Dieses zweite Pulverbild wird zum ersten paßgenau auf die Keramikfolie übertragen. Nach dem Brennen erhält man dann ein Leiterbahnmuster mit verstärkten freiliegenden Kontaktierungsstellen, das im übrigen mit einer dielektrischen Schutzschicht bedeckt ist.

Das zweite Pulverbild kann auch aus einem Material mit geringer Leitfähigkeit gebildet werden. So erhält man Schaltkreise mit integrierten Widerständen. Geeignete Pulver lassen sich in bekannter Weise aus handelsüblichen Dickfilm-Widerstandspasten durch Trocknen und Mahlen herstellen. Wichtig ist hierbei, daß sich - entsprechend der Arbeitsweise in der Dickfilmtechnik - die beiden Pulverbilder dort, wo das Metall an das Widerstandsmaterial anschließt, d.h. im Terminierungsbereich, um etwa 50 - 100 μm überlappen. Überraschenderweise läßt sich auf diese Weise ein fehlerfreier Anschluß der metallischen Leiterbahnen an die Widerstände im Bereich der Terminierung erzielen, während nach einem einstufigen Pulververfahren hergestellte Widerstandskreise - wahrscheinlich aufgrund der unterschiedlichen Schrumpfung der Metall- und Widerstandspulver - an der Terminierung abreißen.

Durch das erfindungsgemäße Verfahren wird die Herstellung feiner Leiterbahnen wesentlich vereinfacht. Es entfallen beispielsweise besondere Arbeitsschritte, wie sie nach dem Stand der Technik für die Erzeugung des negativen Musters durch Auswaschen oder für die Einstellung der elektrischen Leitfähigkeit auf der Hilfsoberfläche notwendig sind.

Die Qualität der nach dem erfindungsgemäßen Verfahren erzeugten Leiterbahnen ist ausgezeichnet. Insbesondere können feinere Leiterbahnen als nach dem Stand der Technik, d.h. mit einer Breite unter 40 μm, hergestellt werden. Es ist auch möglich, leitfähiges Material so auf grüne Keramik aufzutragen, daß das leitfähige Muster beim Brennen der Keramik nicht zerstört wird. Dadurch wird ein besonders wirtschaftliches Verfahren zur Herstellung keramischer Mehrschichtschaltungen ermöglicht.

Das erfindungsgemäße Verfahren läßt sich in vielfacher Weise sehr flexibel an die unterschiedlichsten Aufgabenstellungen und Materialkombinationen anpassen. Dabei ergeben sich wirtschaftliche Vorteile beispielsweise dadurch, daß auch Träger mit geringerer Oberflächengüte oder mit konstruktionsbedingten Aussparungen oder Vertiefungen verwendbar sind.

Die Erfindung läßt sich für die Herstellung feiner Leiterbahnen auf Substraten aller Art, wie sie beispielsweise bei gedruckten Schaltungen und Hybridschaltungen in der Mikroelektronik verwendet werden, anwenden.

Ausführungsbeispiele:

Beispiel 1

Plättchen von 2 mm Dicke und 5x5 cm Größe aus einem Borosilikatglas wurden mit einer Lösung von 1 g Dimethylester der 2,6-Dimethyl-4-(2'-nitrophenyl)-1,4-dihydropyridin-3,5-dicarbonsäure und
1 g Diethylester der 2,6-Dimethyl-4-(2'-nitrophenyl)-1,4-dihydropyridin-3,5-dicarbonsäure
in 10 ml Methylethylketon beschichtet und getrocknet. Die trockene lichtempfindliche Schicht hatte ein Auftragsgewicht von 0,2 mg/cm$^2$.

Die Schicht wurde mit einem Testmuster, welches 25 μm breite Linien und Zwischenräume aufwies, belichtet. Auf das so gebildete klebrige Muster wurde reines Goldpulver mit einer mittleren Teilchengröße von 2 μm mit Hilfe des Vibrationsverfahrens der DE 37 36 391-C1 bis zu einem Auftragsgewicht von 8 mg je cm$^2$ belichteter Fläche aufgetragen. Nach einer Wartezeit von 3 min wurde nach dem gleichen Verfahren reines Wismutpulver aufgetragen, wobei man ein Auftragsgewicht von 0,8 mg/cm$^2$ erreichte.

Die Glasplättchen mit den Pulverbildern wurden 10 min bei 400 ˚C getempert, wobei sich das aus der lichtempfindlichen Substanz gebildete klebrige Muster verflüchtigte. Nach dem Abkühlen auf 70 ˚C wurde eine grüne Keramikfolie (Du Pont Green Tape®) auf das Pulverbild aufgelegt und 1 min lang mit einem Druck von 20 MPa angepreßt. Nach vollständigem Abkühlen wurde die Keramikfolie vorsichtig von dem Glasplättchen abgezogen. Das Pulverbild war nun vollständig auf die Keramikfolie übertragen worden. Die Folie wurde 10 min bei 850 ˚C gebrannt, wodurch fest haftende ununterbrochene Leiterbahnen von 25 μm Breite mit guter Leitfähigkeit auf einem formbeständigen Keramiksubstrat erhalten wurden.

Beispiel 2

Es wurde zunächst wie in Beispiel 1, jedoch mit Plättchen aus Dünnfilmkeramik (99,6 % Al$_2$O$_3$; Rubalit® 710 der Fa. Hoechst CeramTec) als Zwischenträger, gearbeitet. Nach dem Auftragen des Goldpulvers wurde das Plättchen unmittelbar 10 min bei 850 ˚C gebrannt. Man erhielt ein einwandfreies Leiterbahnmuster, welches jedoch nur sehr schwach an der Zwischenträgeroberfläche haftete. Zur Demonstration der Übertragbarkeit wurde ein Blatt CROMALIN®, von dem die Polypropylen-Deckfolie entfernt worden war, mit der klebrigen Schichtseite auf das Muster aufgelegt und mit einem Druck von 0,2 MPa angepreßt. Nach dem vorsichtigen Abziehen waren die Leiterbahnen vollständig übertragen.

Beispiel 3

Ein 5x5 cm großes Dünnfilmkeramikplättchen als Zwischenträger wurde wie in Beispiel 1 beschrieben mit einer lichtempfindlichen Schicht versehen und mit dem Testmuster belichtet. Danach wurde ein Metallpulver mittels des Vibrationsverfahrens aufgetragen und das lichtempfindliche Material durch Ausheizen entfernt. Nun wurde der Zwischenträger mit einer grünen Keramikfolie in Berührung gebracht und das Pulverbild bei 74 °C unter 5 min lang andauerndem Druck auf diese transferiert. Nach Abziehen der Keramikfolie vom Zwischenträger und Brennen in einem Durchlaufofen bei 850 °C wurde ein gesinterter Keramikkörper erhalten, der auf seiner Oberfläche kontinuierliche Leiterbahnen von sehr hohe Güte aufwies. Weitere Verfahrensparameter für verschiedene Leitmetalle sind in der folgenden Tabelle 1 aufgeführt.

## Tabelle 1

| Metallpulver, Korngröße | Ausheiz- -temperatur (°C) | -zeit (min) | Transferdruck (MPa) |
|---|---|---|---|
| Gold, 2 μm | 200 | 3,5 | 6,1 |
| Gold*), 2 μm | 200 | 3,0 | 6,1 |
| Platin, 1,3 μm | 300 | 0,5 | 3,7 |
| Silber, 2 μm | 300 | 0,5 | 3,7 |
| Kupfer, 1,5 μm | 200 | 3,0 | 3,7 |

*) beschichtet mit Haftvermittlern nach DE 38 06 515-C1

Beispiel 4

Mehrere 10x10 cm große Glasplättchen als Zwischenträger wurden mit der in Beispiel 1 beschriebenen lichtempfindlichen Schicht versehen. Jeweils ein Plättchen wurde mit der spiegelbildlichen Negativmaske des Leiterbahnmusters einer der ersten drei Lagen einer Mehrschichtschaltung (Du Pont Green Tape Test Pattern) belichtet. Auf die belichteten Schichten wurde reines Goldpulver (2 μm) aufgetragen. Danach wurden die Zwischenträger 6 min lang auf 350 °C erhitzt, wobei sich das lichtempfindliche Material verflüchtigte. Aus grüner Keramikfolie (Du Pont Green Tape® AT) wurden vier 7,5x7,5 cm große Coupons ausgestanzt, in denen Löcher (vias) zur Verbindung der Leiterbahnmuster der verschiedenen Ebenen ausgestanzt und im Siebdruckverfahren mit einer Goldpaste gefüllt wurden. Auf drei der so vorbereiteten Folien wurden die Zwischenträger mit den passenden Pulverbildern registergenau aufgelegt und 5 min lang bei -74 °C mit 4,5 MPa gepreßt. Nun wurden zwei unbehandelte Foliencoupons, die drei Coupons mit den Pulverbildern und der vierte Coupon, auf dem vorher das Leiterbild der vierten Lage im Siebdruckverfahren aufgebracht worden war, übereinandergelegt. Dieses Laminat wurde entsprechend dem für die Keramikfolie empfohlenen Verfahren verpreßt, vorgeheizt und gesintert. Der elektrische Test zeigte vollständige Funktionsfähigkeit der erhaltenen Mehrlagenschaltung.

Beispiel 5

Ein Glasplättchen wurde wie im Beispiel 1 beschrieben mit einer lichtempfindlichen Schicht versehen, belichtet und mit Goldpulver (2 μm) behandelt. Danach wurde das lichtempfindliche Material durch 8 min langes Ausheizen bei 600 °C entfernt. Ein Zylinder aus Borosilikatglas wurde durch Eintauchen in einen verdünnten handelsüblichen Kleber (UHU® + Dichlormethan etwa 1:10) mit einer klebrigen Oberfläche versehen und auf dem Pulverbild abgerollt. Das übertragene Pulverbild wurde durch Erhitzen auf 700 °C während 10 min zu einem Leiterbahnbild mit ausreichender Haftung an der Glasoberfläche gesintert.

Beispiel 6

Ein Glasplättchen wurde wie im Beispiel 1 beschrieben mit einer lichtempfindlichen Schicht versehen, belichtet und mit Goldpulver (2 μm) behandelt. Das lichtempfindliche Material wurde durch Erhitzen auf 350 °C während 6 min entfernt. Ein zylindrischer Bariumtitanatkörper wurde in eine Lösung nach dem Beispiel 1 der Patentanmeldung P 39 13 116.5 (enthaltend lichtempfindliche Dihydropyridinverbindungen des Beispiels 1 und Wismutnitrat als Haftvermittler) eingetaucht, getrocknet, diffus belichtet und auf diese Weise mit einer klebrigen Oberfläche versehen. Die klebrige Zylinderfläche wurde unter Druck auf dem Pulverbild abgerollt. Das übertragene Pulverbild konnte durch zehnminütiges Brennen bei 900 °C zu Leiterbahnen mit guter Haftung am Barumtitanat gesintert werden.

Beispiel 7

Auf ein 5x5 cm großes Plättchen aus Dünnfilmkeramik wurde ein klebriger photopolymerisierbarer Trockenfilm (Cromalin® 4 der Fa. Du Pont) auflaminiert und bildmäßig belichtet. Nach Auftragen eines Goldpulvers wurde das Plättchen in einem IR-Durchlaufofen auf 600 °C erhitzt bis das lichtempfindliche Material verbrannt war. Das Plättchen mit dem Pulverbild wurde nun mit einer grünen Keramikfolie in Berührung gebracht und 5 min bei 74 °C mit 10 MPa gepreßt. Die Folie mit dem übertragenen Pulverbild wurde vom Zwischenträger abgezogen und in einem Durchlaufofen bei 850 °C gebrannt. Man erhielt einen gesinterten Keramikkörper mit kontinuierlichen Feinleiterbahnen hoher Güte.

Beispiel 8

Auf einen 7,5 x 7,5 cm großen Glasplättchen wurde eine lichtempfindliche Schicht wie in Beispiel 1 erzeugt, mit einem Auflösungsmuster belichtet und mit sphärischem Goldpulver von 2 μm Teilchengröße nach dem Vibrationsverfahren behandelt. Das Plättchen mit dem so erzeugten Pulverbild wurde in ein Becherglas mit Cyclohexan von Raumtemperatur eingetaucht. Dann wurde das Lösungsmittel innerhalb von 10 Minuten auf 50 °C aufgeheizt und wieder abgekühlt. Dabei wurde das lichtempfindliche Material durch Extraktion entfernt. Das Plättchen wurde aus dem Lösungsmittel herausgezogen und getrocknet. Anschließend wurde das Pulverbild durch 5 Minuten langes Pressen bei 74 °C und 4,5 MPa Druck auf Green Tape® übertragen.

Beispiel 9

Borosilikatglasplatten (10 x 10 cm², 2 mm dick) wurden wie in Beispiel 1 beschrieben mit einer lichtempfindlichen Beschichtung versehen, mit einem Testmuster belichtet und mit Goldpulver behandelt. Durch 6 min langes Erhitzen auf 350 °C wurde das lichtempfindliche Material entfernt, sodaß Goldpulverbilder mit geringer Haftung auf den Glasplatten zurückblieben.

Auf eine dieser Glasplatte wurde eine grüne Keramikfolie aufgelegt und beides bei 70 °C mit 4,4 MPa 5 min lang gepreßt. Die noch warme Keramikfolie wurde sofort von der Glasplatte abgezogen. Nach dem Abkühlen wurde eine weitere Glasplatte mit einem Goldpulverbild paßgenau auf die Keramikfolie aufgelegt und erneut gepreßt. Auch das zweite Pulverbild wurde vollständig übertragen.

Nach dem Brennen erhielt man fehlerfreie Leiterbahnzüge mit einer gegenüber dem Beispiel 1 erhöhten Leitfähigkeit.

Beispiel 10

Das Verfahren des Beispiels 9 wurde wiederholt, wobei jedoch das zweite Pulverbild nicht paßgenau sondern um 90° gedreht aufgelegt wurde. Nach dem Brennen erhielt man Leiterbahnen, die vollständig auf dem Keramikkörper hafteten und auch an den Kreuzungspunkten nicht unterbrochen waren.

Beispiel 11

Es wurde wie in den Beispielen 9 und 10 gearbeitet, jedoch wurde das zweite Pulverbild aus Silber- oder Platinpulver (siehe Beispiel 3) hergestellt. Bei weiteren Versuchen wurde nach dem Übertragen eines Gold- und eines Silberpulverbildes noch ein drittes Pulverbild aus Platin vor dem Brennen auf die Keramikfolie übertragen. In allen Fällen wurden die Pulverbilder vollständig und ohne Beschädigung übertragen.

Beispiel 12

Für diesen Versuch wurde ein übliches Widerstands-Testmuster verwendet, das aus zwei Masken besteht. Die erste Maske stellt hierbei die metallischen Zuleitungen und Terminierungen dar, während die zweite Maske die Widerstandsbereiche definiert. Beide Masken überlappen sich im Terminierungsbereich um etwa 50 $\mu$m.

Zwei Glasplatten wurden wie im Beispiel 1 mit einer lichtempfindlichen Beschichtung versehen. Auf die erste Platte wurde nach Belichtung durch die erste Maske Goldpulver aufgetragen. Auf die zweite Platte nach Belichtung durch die zweite Maske ein Pulver aus einer getrockneten handelsüblichen Dickfilm-Widerstandspaste auf der Basis Glasfritte-Wismutoxid-Rutheniumoxid aufgetragen. Nach dem Entfernen der lichtempfindlichen Schicht durch Erhitzen wurde zunächst das Pulverbild von der ersten, dann das von der zweiten Glasplatte auf die gleiche grüne Keramikfolie übertragen. Nach dem Brennen erhielt man einen Keramikkörper, der Widerstandsbereiche aufwies, die fehlerfrei mit den Goldleiterbahnen kontaktiert waren.

In einem Vergleichsversuch wurde eine lichtempfindlich beschichtete Glasplatte mit der ersten Maske belichtet, Goldpulver aufgetragen, sodann durch die zweite Maske belichtet und Widerstandspulver aufgetragen. Nun wurde die lichtempfindliche Schicht durch Erhitzen entfernt und das kombinierte Gold-Widerstands-Pulverbild durch Pressen auf eine grüne Keramikfolie übertragen. Nach dem Brennen zeigte sich, daß in den Terminierungsbereichen die Verbindung der Goldleiterbahnen zu den Widerstandsbereichen unterbrochen war.

**Patentansprüche**

1. Verfahren zur Herstellung von feinen Leiterbahnen für elektrische Schaltkreise auf einem Träger unter Benutzung einer Hilfsoberfläche eines Zwischenträgers, enthaltend die Schritte

   a) Auswahl des Trägers und des Zwischenträgers dergestalt, daß deren Beschaffenheit es gestattet, beide nach einem Inkontaktbringen wieder voneinander zu trennen,

   b) Ausbildung eines Musters, welches die Form der Leiterbahnen festlegt, auf der Hilfsoberfläche,

   c) Auftragen eines elektrisch leitfähigen Materials auf die Hilfsoberfläche in der durch das Muster festgelegten Form,

   d) Entfernung des Musters von der Hilfsoberfläche, wodurch allein das leitfähige Material zurückbleibt,

   e) Anheften des leitfähigen Materials an den Träger mit einer Haftkraft, die größer als die Haftkraft des leitfähigen Materials an der Hilfsoberfläche ist, durch Inkontaktbringen von Träger und Hilfsoberfläche,

   f) Trennen von Träger und Hilfsoberfläche, wobei das elektrisch leitfähige Material in der vom Muster bestimmten Form am Träger haften bleibt, dadurch gekennzeichnet, daß

   1. das Muster ein positives klebriges Muster ist,

   2. das elektrisch leitfähige Material ein Pulver ist, welches hauptsächlich aus einem oder mehreren Metallen und/oder Legierungen besteht und

   3. das in der Form des positiven klebrigen Musters vorhandene Pulver zu einem Leiterbahnmuster verdichtet wird.

2. Verfahren nach Anspruch 1,
   dadurch gekennzeichnet, daß
   das positive klebrige Muster durch bildmäßige Bestrahlung einer positiv oder negativ arbeitenden strahlungsempfindlichen Beschichtung erzeugt wird.

3. Verfahren nach Anspruch 2,
   dadurch gekennzeichnet, daß
   die strahlungsempfindliche Beschichtung aus einem photopolymerisierbaren Gemisch besteht, welches klebrig ist und durch Bestrahlung seine Klebrigkeit verliert.

4. Verfahren nach Anspruch 2,

EP 0 457 071 A2

dadurch gekennzeichnet, daß
die strahlungsempfindliche Beschichtung aus einem Stoff oder einem Stoffgemisch besteht, welche durch Bestrahlung klebrig werden.

5. Verfahren nach Anspruch 4,
dadurch gekennzeichnet, daß
die strahlungsempfindliche Beschichtung Dihydropyridinverbindungen enthält.

6. Verfahren nach Anspruch 5,
dadurch gekennzeichnet, daß
die strahlungsempfindliche Beschichtung Abkömmlinge des Nitrophenyldihydropyridins enthält.

7. Verfahren nach einem der Ansprüche 1 bis 6,
dadurch gekennzeichnet, daß
das Pulver neben den metallischen Bestandteilen noch Stoffe zur Beeinflussung der Haftung der Leiterbahnen auf dem Träger und/oder der Sinterung des Pulvers enthält.

8. Verfahren nach einem der Ansprüche 1 bis 7
dadurch gekennzeichnet, daß
wenigstens der Träger oder der Zwischenträger so flexibel ist, daß er beim Trennen vom anderen abgezogen werden kann.

9. Verfahren nach einem der Ansprüche 1 bis 8,
dadurch gekennzeichnet, daß
das Pulverbild zur Verdichtung einem Sinterprozeß unterworfen wird.

10. Verfahren nach einem der Ansprüche 4 bis 9,
dadurch gekennzeichnet, daß
die Schritte b) bis f) unter Verwendung weiterer Zwischenträger mit dem gleichen oder einem anderen Muster sowie mit dem gleichen oder einem anderen elektrisch leitfähigen Material einmal oder mehrmals wiederholt werden und daß die Verdichtung danach erfolgt.

11. Verfahren nach Anspruch 10,
dadurch gekennzeichnet, daß
bei der Wiederholung ein anderes Muster und ein Material mit geringer elektrischer Leitfähigkeit verwendet werden.

12. Verfahren nach Anspruch 10,
dadurch gekennzeichnet, daß
das bei der Wiederholung übertragene Pulverbild neben Bereichen mit leitfähigem Material auch Bereiche mit dielektrischem Material enthält.

13. Verfahren nach einem der Ansprüche 1 bis 12,
dadurch gekennzeichnet, daß
der Träger mindestens in seiner Oberflächenschicht Stoffe enthält, die bei mindestens einer Temperatur zwischen 0 und 200 °C gegenüber dem leitfähigen Material als Klebstoff wirken.

14. Verfahren nach einem der Ansprüche 1 bis 13,
dadurch gekennzeichnet, daß
der Zwischenträger und/oder der Träger aus einer grünen Keramikfolie besteht und der Schmelzpunkt des Metalls im Pulver über der Sintertemperatur der Keramik liegt.

15. Verfahren nach einem der Ansprüche 1 bis 9,
dadurch gekennzeichnet, daß
der Zwischenträger temperaturbeständig ist und das aufgetragene Pulver zwischen den Schritten d) und e) einem Sinterprozeß unterzogen wird.

16. Verfahren nach einem der Ansprüche 1 bis 15,

9

dadurch gekennzeichnet, daß
das Muster durch thermische Verflüchtigung, Verbrennen oder Extrahieren entfernt wird.

17. Verfahren nach einem der Ansprüche 1 bis 16,
dadurch gekennzeichnet, daß
das Pulver aus einem durch Vibration verdichteten Pulverbett aufgetragen wird.

18. Ein- oder Mehrschichtschaltkreis, hergestellt nach dem Verfahren nach einem der Ansprüche 1 bis 17.